# EUROPEAN PATENT SPECIFICATION

(11) **EP 0 538 252 B1**
(45) Date of publication and mention of the grant of the patent: **04.12.1996**
(21) Application number: 90911030.6
(22) Date of filing: 12.07.1990
(51) Int. Cl.: G01J 3/00, G01J 3/453, G01R 23/16, H03M 1/08, H03M 1/20

(54) **TECHNIQUE FOR IMPROVING THE RESOLUTION OF AN A/D CONVERTER IN A SPECTROMETER USING DITHER**
TECHNIK ZUR VERBESSERUNG DER AUFLÖSUNG EINES A/D WANDLERS IN EINEM SPEKTROMETER UNTER VERWENDUNG EINES VIBRATIONSSIGNALS
TECHNIQUE DESTINEE A AMELIORER LA RESOLUTION D'UN CONVERTISSEUR ANALOGIQUE NUMERIQUE DANS UN SPECTROMETRE UTILISANT UN SIGNAL DE VIBRATION

(43) Date of publication of application: 28.04.1993
(73) Proprietor: BIO-RAD LABORATORIES, INC., Hercules California 94547 (US)
(72) Inventor: CURBELO, Raul, Lexington, MA 02173 (US)
(74) Representative: Stuart, Ian Alexander
(86) International application number: US9003910
(87) International publication number: WO9201210

(56) References cited:
- EP-A- 0 037 259
- DE-A- 3 900 247
- GB-A- 2 144 285
- US-A- 4 034 191
- US-A- 4 070 708
- US-A- 4 797 923

## Description

### BACKGROUND OF THE INVENTION

The present invention relates generally to signal processing, and more specifically to circuitry for improving the resolution of an analog-to-digital converter (A/D converter).

A/D converters are well known devices for providing a digital representation of an analog voltage presented at the A/D input. Typical A/D converters provide a 16-bit resolution for a single conversion, but this is not fundamental. However, depending upon the number of bits resolution provided by the A/D converter in any single conversion, the resolution is limited.

Certain classes of input signal that must be digitized are characterized by a high ratio between maximum and minimum values. An example is the signal from a Fourier transform spectrometer where it is often the case that the amount of input radiation that the spectrometer can accommodate is limited by the dynamic range of the A/D converter.

A Fourier transform spectrometer typically includes an interferometer into which an infrared bear to be analyzed and a monochromatic reference beam are directed. The interferometer includes a mechanism for each input bear to be split into two or more beam components. The beam components travel separate paths and are then recombined so as to interfere with each other. An optical element in one of the paths is scanned over a range of positions to vary the path length of one beam component relative to that of the other. The maximum excursion from zero path difference determines the maximum resolution of the spectral measurement.

There are many kinds of interferometers, but the most commonly used type for Fourier transform spectrometers is a Michelson interferometer. The interferometer has a fixed mirror and a movable mirror, and may be operated in a rapid scan mode or a step scan mode. In a rapid scan Interferometer the mirror is driven at a nominally constant velocity over a portion of its travel. In a step scan interferometer, the movable mirror is moved in small increments and stopped for each measurement.

Each of the input beams is split at a beam splitter with one portion traveling a path that causes it to reflect from the fixed mirror and another portion traveling a path that causes it to reflect from the movable mirror. The portions of each beam recombine at the beam splitter, and due to optical interference between the two portions, the intensity of the monochromatic beam and each frequency component of the infrared beam are modulated as the mirror moves. For constant mirror velocity, the frequency for a particular component is proportional to the component's optical frequency and the mirror velocity. The recombined beams are directed to appropriate detectors.

The detector output represents the superposition of these modulated components, and when sampled at equal increments of mirror movement, provides an interferogram whose Fourier transform yields the desired spectrum. All these modulated components are in phase when the two paths are equal, and the resultant superposition produces a relatively huge peak in intensity, referred to as the centerburst.

The signal to noise (S/N) ratio in the interferogram is very high compared to the S/N ratio in the associated spectrum. This is because the signal contributions from the individual spectral resolution elements add linearly at the centerburst while the noise contributions add as the square root.

The monochromatic beam provides a nominally sinusoidal reference signal whose zero crossings occur each time the moving mirror travels an additional one quarter of the reference wavelength. A pulsed sampling signal is derived from the sinusoidal signal, typically from the zero crossings, and is used to trigger the data acquisition electronics to provide regularly sampled values for the interferogram. With the appropriate choice of mirror velocity, the output signal can be made to fall within a convenient range of modulation frequencies, as for example in the audio range.

The frequency of the sampling signal is referred to as the principal sampling frequency and is designated f(prin). The inverse of the principal sampling frequency is referred to as the principal sampling interval. Depending on the spectral range of interest, the sampling interval may be the distance between adjacent zero crossings of the sinusoidal signal, or may be a multiple of that distance.

The mirror velocity may be controlled and rendered substantially constant by generating a reference signal at the desired frequency f(prin) by frequency division of a signal from a crystal oscillator, and providing servo control of the mirror motion so the monochromatic signal tracks the reference signal. For a highly uniform mirror velocity, the time duration of a sampling interval (which is a constant unit of distance related to the wavelength of the monochromatic reference beam) is very nearly constant. Therefore, it is not uncommon for those in the art to use time and distance somewhat interchangeably.

Additionally, it is common to exclude data points (or not take them) for those portions of the mirror travel (typically a fraction of a millimeter) where the mirror's motion is being reversed. Thus the term "scan" should be understood generally to refer to the portion of the mirror's travel where data points are taken and used for the spectral measurement. Moreover, data acquisition typically occurs for only one direction of mirror movement.

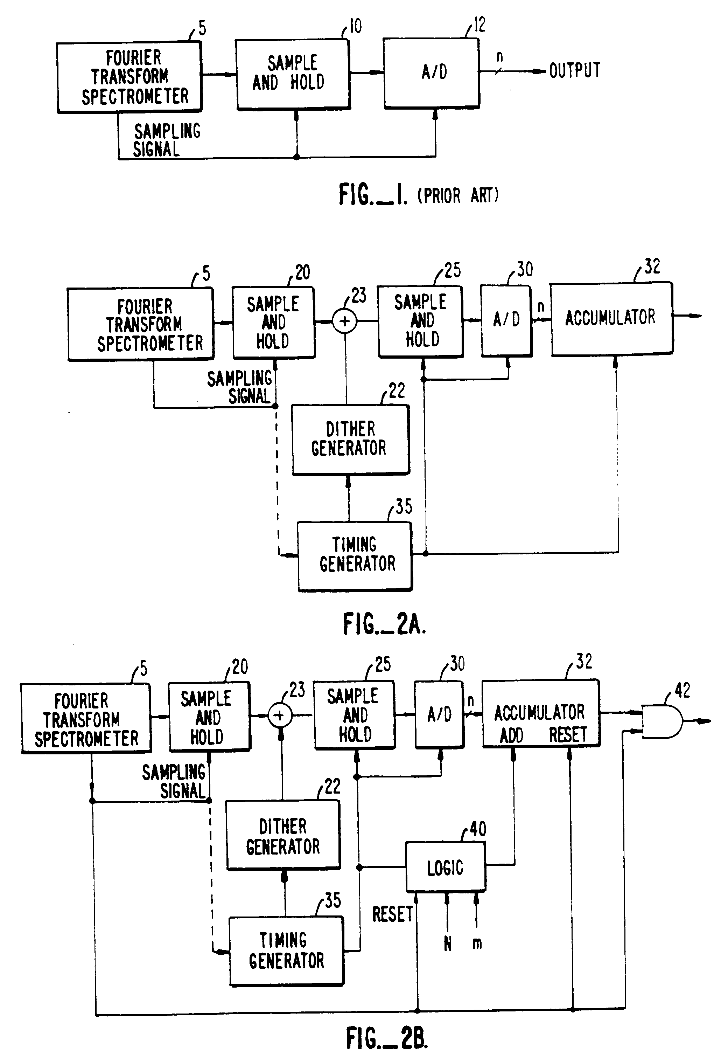

Fig. 1 shows a prior art circuit for digitizing the analog spectrometer signal. For present purposes, the interferometer, detector, detector amplifiers, and filters as appropriate are shown as a block labeled Fourier transform spectrometer 5. It should be understood that the complete spectrometer system typically further includes the illustrated circuitry as well as various control circuits and a dedicated computer (not shown).

The analog signal from Fourier transform spectrometer 5 is communicated to the voltage input of a sample and hold (S/H) circuit 10, which provides a constant voltage level at its output when clocked by a sampling signal (at f(prin)) at its sampling input. This level is held until the A/D conversion is completed. This voltage level is communicated to an analog-to-digital A/D converter 12, which is also clocked by the sampling signal. Assuming A/D converter 12 to have an n-bit output (n=16 is typical), the characteristic resolution is one part in 2ⁿ. For a 16-bit A/D converter and analog input signals covering ±10 volts, the digitization increment is about 0.3 mv.

The output from the A/D converter is communicated to the dedicated computer where it is stored until all the data points in the interferogram have been acquired. The interferogram is then subjected to processing steps including a fast Fourier transform (FFT) to convert it into a spectrum. In some instances, multiple scans are made and the resultant interferograms are averaged before the FFT. For the averaging to provide a statistical improvement (increased S/N ratio), a given point on the interferogram should fall on a different part of the A/D converter's range. This will normally be the case since standard practice is to set up the spectrometer so that the noise spans at least a few digitizing increments.

In many cases, the resolution of the A/D converter sets the maximum S/N ratio that can be achieved in the spectrum in any one scan. This limitation can be partially, but not completely overcome by using a technique known as gain ranging. This technique entails increasing (for example, by a factor of 16) the analog voltage that is input to the S/H circuit and A/D converter when the mirror is away from the vicinity of the centerburst position.

GB-A-2144285A and EP-A-0037259 show systems in which a waveform generated by a signal generator is added to an analogue signal prior to digitisation

The present invention provides a technique for improving the resolution of an A/D converter to enable the measurement of signals having a high dynamic range, as in connection with sampling and digitizing the analog output signal from a Fourier transform spectrometer.

The invention provides a method of providing a digitised spectrometer signal, said method comprising the steps of:
generating using a spectrometer a modulated beam of analytical radiation as an optical element in the spectrometer is scanned over a range of positions defining a scan, the scan being subdivided into a sequence representing sample intervals; and
for each sampling interval:
   (i) generating on a signal channel an analogue signal representing the intensity of the modulated beam of analytical radiation;
   (ii) digitising a plurality of sampled signal values of said analogue signal to provide corresponding digitized values;
characterised in that;
the signal channel has a bandwidth that is wider than the range of frequencies that characterises the spectrometer output signal so that the spectrometer signal provides noise over this bandwidth; and that at least some of the digitized values are averaged.

The invention further provides a spectrometer having digitizing apparatus for providing a digitized spectrometer signal, the spectrometer providing a modulated beam of analytical radiation as an optical element in the spectrometer is scanned over a range of positions defining a scan, the scan being subdivided into a sequence of sampling intervals, the digitizing apparatus comprising:
means for generating on a signal channel an analogue signal representing the intensity of the modulated beam of analytical radiation;
means for digitizing a plurality of sampled signal values of said analogue signal to provide corresponding digitized values;
characterised in that:
(i) the signal channel has a bandwidth that is wider than the range of frequencies that characterises the spectrometer output signal so that the spectrometer signal provides noise over this bandwidth; and
(ii) averaging means are provided to average at least some of the digitized values.

Thus, the analog voltage to be digitized is effectively combined with a dither signal, the resultant voltage is then sampled a plurality of times, and at least some of the sampled values are digitized (by the A/D converter). At least some of the digitized values are co-added (in effect averaged) to provide an output having a digitized error reduced by a factor of up to the square root of the number of values averages. The technique is typically carried out with a high speed A/D converter so that a large number of samples of the fluctuating voltage can be digitized within a given sampling interval.

The bandwidth of the signal channel is preferably a significant factor (say 10 or greater) beyond the spectral range of interest.

The present invention, by reducing the digitization error, and thereby increasing the dynamic range, allows the use of greater source energy in the spectrometer without reducing sensitivity or requiring an A/D converter having more bits of resolution. A further advantage of the invention is that it tends to average out non-uniformities in the A/D converter step size (digitizing increment), which further enhances the accuracy of the measurement.

A further understanding of the nature and advantages of the present invention may be realized by reference to the remaining portions of the specification and the attached drawings.

### BRIEF DESCRIPTION OF THE DRAWINGS

Fig. 1 (described above) is a block diagram cf prior art circuitry for providing digitized values corresponding to the signal from a Fourier transform spectrometer;
Figs. 2A and 2B are block diagrams illustrating an example of circuitry for increasing the effective resolution of an A/D converter used to digitize the signal from a Fourier transform spectrometer; and
Fig. 3 is a block diagram of a second example of such circuitry
Figs. 4 and 5 illustrate suitable waveforms for the dither signal used with the above examples of circuitry
Figs. 6A and 6B are block diagrams of a third example of such circuitry;
Fig. 6C illustrates a suitable waveform for the dither signal for the circuitry of Figs. 6A and 6B; and
Fig. 7 is a block diagram illustrating an embodiment of circuitry according to the present invention.

### DESCRIPTION OF SPECIFIC EMBODIMENTS

### Introduction

The present invention provides improved apparatus and method for generating a digital representation of a time-varying analog signal, and will be described in the context of digitizing the analog signal from a Fourier transform spectrometer (referred to as the spectrometer output signal). Except as otherwise stated, it will be assumed that the spectrometer is generally as described above, and may include a gain ranging amplifier.
Figures 2-6 illustrate examples of circuitry for increasing the effective resolution of an A/D converter, and waveform for use in such circuitry. These examples are provided for illustration only.

### First Example

Fig.2A is a block diagram of circuitry according to a first example. The analog signal from spectrometer 5 is communicated to a first sample and hold (S/H) circuit 20, which is clocked by the sampling signal at f(prin) from the monochromatic reference system. S/H circuit 20 provides a DC level corresponding to the value of the voltage of the input signal at the time of each sampling.

A dither generator 22 generates a dither signal whose characteristics will be described below. The dither is superimposed on the output from S/H circuit 20 at a summing node 23. The resulting fluctuating voltage is communicated to the input of a second S/H circuit 25, the held level of which is communicated to the input of an analog to digital (A/D) converter 30. The A/D converter's n-bit digital output is communicated to an accumulator 32, which communicates with a computer interface (not shown).

A timing generator 35 clocks S/H circuit 25, A/D converter 30, and accumulator 32. Timing generator 35 runs at a frequency typically one or more orders of magnitude above the frequency of the sampling signal f(prin). Accordingly, for each value of output voltage held by S/H circuit 20, a plurality of held levels are generated by S/H circuit 25. The output levels from S/H circuit 25 are digitized by A/D converter 30 and communicated to accumulator 32. Accumulator 32 co-adds the digital outputs from A/D converter 30, and outputs a single value. Assuming that the same number of digitized samples are co-added every time, the output from the accumulator is equivalent to the average value, differing only by an overall scale factor.

The sampling signal's communication with timing generator 35 is shown in phantom. This is because timing generator 35 may be synchronous (in which case the sampling signal would define the clock rate), or it may be asynchronous. In a typical application (synchronous or asynchronous), timing generator 35 may be run at a frequency of 10-300 times the frequency of the principal sampling signal. S/H circuit 25, A/D converter 30, or accumulator 32 may be gated so that a smaller number (say 8-256) of digitizations are co-added. These numerical ranges are merely representative. Co-adding as few as 2-4 digitizations provides a meaningful improvement.

The circuit components are generally off-the-shelf items. The S/H circuits may be modules, integrated circuits. or (in the case of S/H circuit 25) circuitry incorporated into the front end of A/D converter 30. Summing node 23 may be an operational amplifier. A high-speed A/D converter capable of operation at 500 kHz is available from Analogic, Woburn, Massachusetts. Accumulator 32 may be a separate hardware device or may be implemented in software as part of the dedicated computer.

For a rapid scan system, timing generator 35 may comprise a phase locked loop for generating a signal at a frequency that is defined multiple of f(prin). Alternatively a signal at a frequency higher than f(prin) can be derived from the same crystal oscillator that is used to generate the reference signal that provides the servo control for the mirror drive, but using a smaller frequency division factor. A step scanning system is normally driven off a clock.

If N is the number of digital outputs that are co-added, the result is a resolution increased by a factor of up to N^{1/2} relative to the resolution obtainable from a single digitization of A/D converter 30. This benefit can be exploited by increasing the input radiation power level to increase the detector signal level relative to the noise. The A/D converter must still accommodate the increased signal, which can be achieved by reducing the gain in the signal channel or providing an S/H circuit and A/D converter capable of accepting a larger range of input voltages. More generally, the invention's benefit can be exploited by relieving other constraints that were imposed by the dynamic range limitations of the A/D converter.

In addition to the increased resolution, the dither signal has the effect of averaging out possible local non-uniformities in the A/D converter step size (digitizing increment).

There is no requirement that accumulator 32 co-add all digitized values from A/D converter 25, that the A/D converter digitize all values from S/H circuit 25, or that S/H circuit 25 sample over the entire principal sampling interval. Indeed, any one or more of these circuit elements may be gated so that only values of the fluctuating voltage occurring during a portion of the principal sampling interval contribute to the co-added result.

Fig. 2B shows a specific example incorporating circuitry for gating accumulator 32. In this case, the signal from timing generator 35 clocks S/H circuit 25 and A/D converter 30, but is communicated to a logic circuit 40.

Logic circuit 40 represents one way of gating the circuitry so that fewer than all possible values are co-added. Logic circuit 40 is responsive to a binary code representative of the maximum number, N, of values that can be co-added and a binary code representative of a number m which is less than or equal to N. The principal sampling signal is communicated to a reset input on logic circuit 40, a reset input on accumulator 32, and a control input of a gate network 42. Logic circuit 40, upon receiving a reset pulse from the principal sampling signal, counts upwards to block the first m pulses of the signal from timing generator 35, and then passes the remaining pulses in order to cause accumulator 32 to co-add only those values from the A/D converter after the first m have been ignored.

If m=0, N digitized values are co-added and the A/D output has its resolution increased by a factor of up to N^{1/2}. For example, if m=0 and N=256, the accumulator output resulting from averaging 16-bit outputs has an effective resolution of up to 20 bits. If N=1, the accumulator only acts to buffer the A/D output.

### Second Example

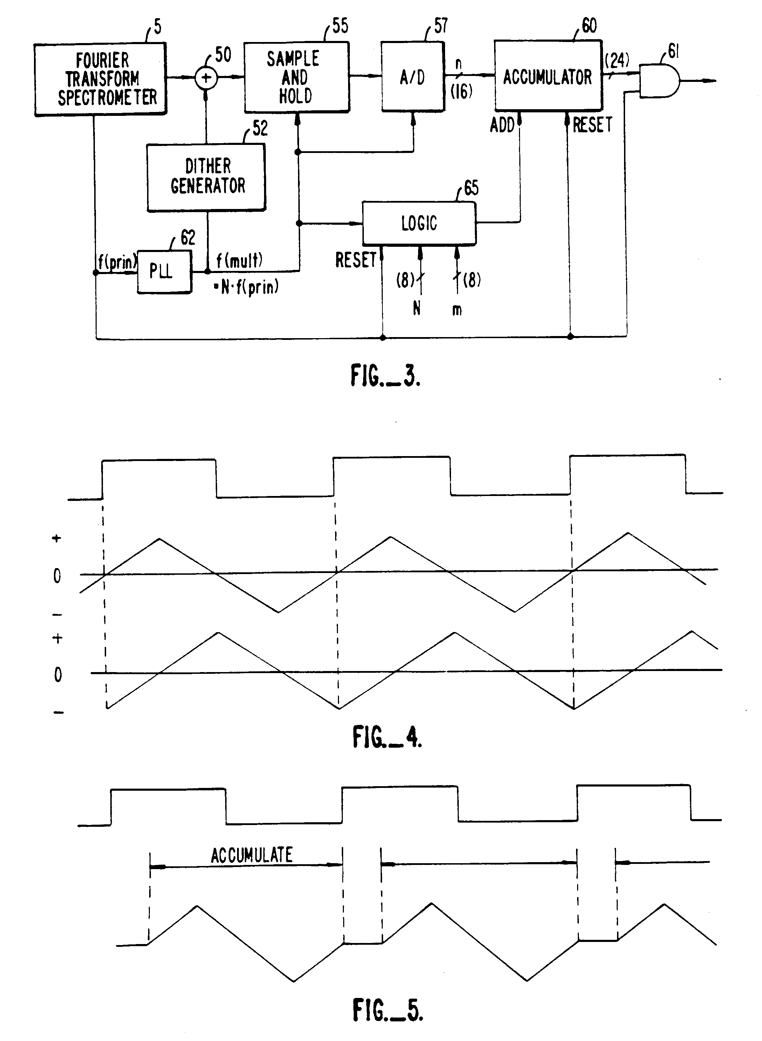

Fig. 3 is a block diagram of circuitry according to a second example. This example is shown incorporating gating circuitry as shown in Fig. 2B, This embodiment differs from the embodiment of Figs. 2A and 2B in that the signal from the spectrometer has the dither directly superimposed on it prior to being sampled and held. More particularly, the analog spectrometer signal is communicated to a summing node 50 as is the output from a dither generator 52. The resulting voltage is communicated to the input of an S/H circuit 55, the held level of which is communicated to the input of an A/D converter 57. The A/D converter's n-bit digital output is communicated to an accumulator 60. The accumulator output is communicated to the data inputs of a gate network 61, the output of which communicates with the computer interface.

A timing generator, shown as a phase locked loop 62, generates a signal at a frequency f(mult) that is a multiple of the principal sampling frequency f(mult)=N.f(prin). The signals at f(prin) and f(mult) should be phase locked to avoid spurious effects. The signal at f(mult) is used to clock S/H circuit 55 and A/D converter 57, and is also communicated to a logic circuit 65 whose operation is as described above in connection with Fig. 2B.

The example of Fig. 3 has the advantage over that of Figs. 2A and 2B in that it requires only a single sample and hold circuit. Possibly offsetting that benefit is that the output is an integrated signal which has the effect of multiplying the spectrum by a factor F=(sin x)/x, where x=πf/f(prin). Therefore, F=1 for f=0 and F=0 for f=f(prin). However, since the spectrum only contains frequencies below f(prin)/2, the factor F ranges from 1.0 to 2/π (approximately 0.6), which is a relatively small correction factor to take care of.

### Dither Signal Characteristics

The dither may be a random or pseudorandom signal or it may have a regular waveform such as a triangular wave. If the dither signal is random, the randomness may be derived from the thermal noise from a diode. The value of the dither signal, time averaged over that portion of the principal sampling interval that corresponds to those digitized values that are co-added should be constant over the entire interferometer scan. A random dither signal centered about a DC level will normally meet this constraint whether or not all values are co-added. While the average value of the dither signal must be constant over an entire interferometer scan, it need not be constant from scan to scan.

If the dither signal has a non-zero time average, the result is a constant offset to the interferogram. This is not a problem since the Fourier transform maps this offset to zero frequency. In any event, the data processing software will often remove the average value from the interferogram before performing the FFT.

The dither signal spectrum should not overlap with the spectral range of interest. For example, if the principal sampling frequency (in wave number units) is about 16,000 cm⁻¹, corresponding to a laser wavelength of 0.6328 microns, the spectral range that can be measured is theoretically (Nyquist's theorem) about 0-8000 cm⁻¹, and practically about 10 cm⁻¹ to 7000 cm⁻¹. Accordingly, the dither can be put in a range of 7000-9000 cm⁻¹ (the signal power in the range 8000-9000 cm⁻¹ folds back to the range 7000-8000 cm⁻¹). Alternatively, the dither can be put in the range between 0 and the smallest wavenumber in the practical range of operation (say 10 cm⁻¹).

The above condition on the dither signal spectrum is not absolute. To the extent that the dither signal is a periodic waveform containing discrete frequency components, it could be allowed to overlap or fold into the spectral range of interest. It would appear as one or more spikes in the spectrum, that could be removed by software. However, since it is usually easy to locate the dither outside the spectral range of interest, it is preferred to do so.

The dither signal should be characterized by an amplitude that spans at least a few digitizing increments. A factor of 5-20 is generally appropriate. Therefore, where the digitizing increment is about 0.3 mv, the dither amplitude should be a few to several millivolts. It is beneficial to use a larger dither amplitude, which has the effect of reducing systematic errors in the A/D converter.

When multiple interferometer scans are to be taken, the dither signal can be varied from scan to scan. This can be accomplished by varying the dither signal's phase or waveform randomly or pseudorandomly from scan to scan. This tends to be most beneficial when the number of scans to be co-added is large relative to the number of digitized values averaged for each sampling interval in each scan.

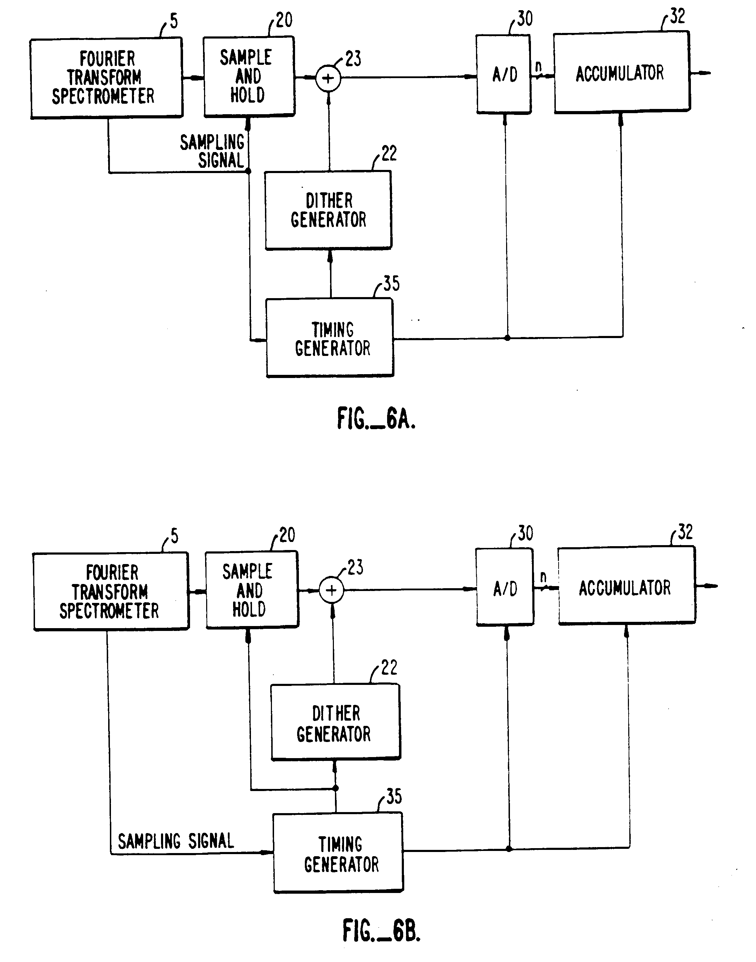

Figs. 4 and 5 are timing diagrams illustrating the use of a non-random dither signal, both for the case where all values generated during the principal sampling period are co-added and for the case where one or more of S/H circuit 25 (or 55), A/D converter 30 (or 57), or accumulator 32 (or 60) are gated to limit the number of values that contribute to the co-added measurement.

Fig. 4 is a timing diagram illustrating suitable dither signals for the case where values generated over the entire principal sampling interval are co-added. The square wave defines the principal sampling period. The dither signals are triangular waves (shown centered at zero, but this is not necessary) with a period equal to the principal sampling interval. The phase is largely insignificant, and two possibilities are illustrated.

Fig. 5 is a timing diagram illustrating the case where the values generated over only part of the principal sampling interval are co-added. In the specific example shown, potential values from the initial part of the principal sampling interval are excluded from the accumulator, so that the effective sampling interval is shorter. The dither signal is a series of triangular wave segments, each having a period equal to the effective sampling interval, but repeated at intervals equal to the principal sampling interval.

### Third Example

Fig. 6A is a block diagram of circuitry according to a third example of the present invention. This example corresponds to the first embodiment, illustrated in Fig. 2, and corresponding reference numerals are used. This example lacks a second S/H circuit, corresponding to S/H circuit 25 in Fig. 2. The purpose of S/H circuit 25 is to hold the fluctuating voltage long enough for A/D converter 30 to perform the actual conversion. The third example eliminates the need for the second S/H by use of a dither signal having a particular characteristic.

Fig. 6B shows a variant of the third example where S/H circuit 20 is clocked by timing generator 35 rather than the principal sampling signal. This may be preferred where the S/H circuit is not capable of holding the voltage level for an entire principal sampling interval. This could be the case where the S/H circuit and A/D converter are packaged in a single module (with access to add the dither), and the S/H isn't intended to be clocked much less frequently than the A/D converter.

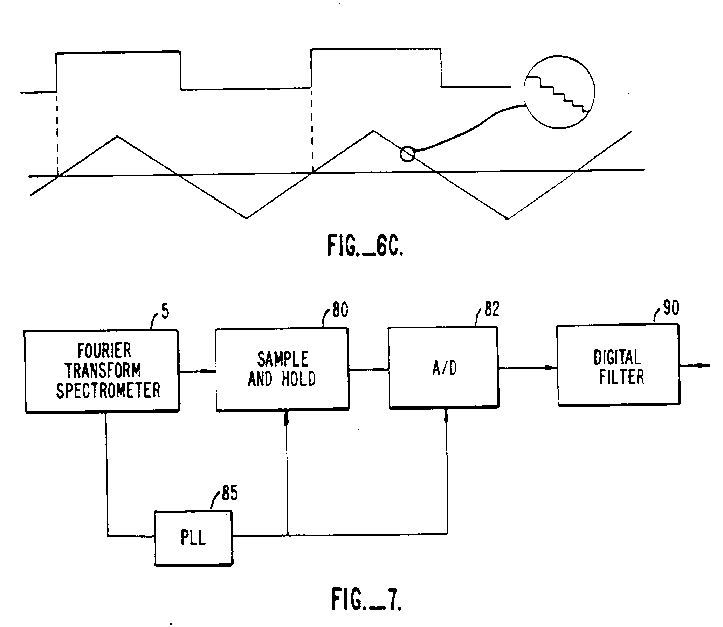

Fig. 6C is a timing diagram illustrating a dither signal wave form suitable for the third example. Specifically, the dither signal has a waveform characterized by steps having a width corresponding to the intervals at which the A/D converter is clocked. Thus each step is longer in duration than the interval during which the A/D converter does its conversion and proper A/D conversion can occur. This is shown in the specific context of a triangular wave where the steps are uniform in height and contiguous. Other possibilities include rectangular pulses of random height but constant width. The pulses could be spaced from each other so long as they occur synchronously with respect to the clocking of the A/D converter.

### Embodiment

Fig. 7 is a block diagram of circuitry according to an embodiment of the present invention. This embodiment corresponds generally to the second example, illustrated in Fig. 3, but differs primarily in that there is no separate dither generator. Assume that the maximum frequency of interest is Fₘₐₓ (in appropriate units). The signal channel bandwidth is increased by a significant factor to include detector and/or amplifier noise up to a maximum frequency of MFₘₐₓ.

Assuming white noise, the noise is increased by a factor of the square root of the bandwidth expansion factor. The gain can be reduced by this factor, and the total noise will still span a few digitizing increments, notwithstanding the fact that the noise in the range up to Fₘₐₓ is less than a digitizing increment. With this reduction in gain, the input radiation to the spectrometer can be increased. A bandwidth expansion corresponding to M≥10 is typically suitable.

To effectively sample the spectral range between 0 and Fₘₐₓ, the sampling frequency must be at least 2Fₘₐₓ. However, in order that the noise between Fₘₐₓ and MFₘₐₓ not fold into the range between 0 and Fₘₐₓ, the sampling frequency must exceed (H+1)Fₘₐₓ. This would cause the noise between (M+1)Fₘₐₓ/2 and MFₘₐₓ to fold into the range between Fₘₐₓ and (M+1)Fₘₐₓ/2, keeping it out of the range between 0 and Fₘₐₓ, which is the range of interest.

A Fourier transform spectrometer 5', having the bandwidth-expanded signal channel communicates its output signal to the input of an S/H circuit 80, the held level of which is communicated to the input of an A/D converter 82. A phase locked loop 85 generates a signal at a multiple of the principal sampling frequency f(prin) that is at least as high as (M+1)Fₘₐₓ/2. The digitized values from A/D converter 82 are communicated to a digital filter 90. Normally, digital filter 90 is not a separate unit, but is inherently part of the FFT software. However, for certain instances where it is desired to avoid doing the FFT with so large a number of data points, a separate hardware or software digital filter can be used. In such a case, the output of the digital filter would be the interferogram with a frequency content up to Fₘₐₓ.

### Conclusion

In conclusion, it can be seen that the present invention provides a simple technique for increasing the resolution of an A/D converter so as to increase the dynamic range of the measurement system. The invention provides a further benefit in that it tends to average out local non-uniformities in the A/D converter step size.

While the above is a complete description of the preferred embodiment of the invention, various modifications, alternative constructions, and equivalents may be employed. For example, with respect to the embodiment, the increased noise can be achieved by a more modest increase in bandwidth coupled with a preamplifier gain that increases with frequency.

Accordingly, the above description and illustrations should not be taken as limiting the scope of the invention which is defined by the appended claims.

## Claims

1. A method of providing a digitised spectrometer signal, said method comprising the steps of:
generating using a spectrometer (7) a modulated beam of analytical radiation as an optical element in the spectrometer (7) is scanned over a range of positions defining a scan, the scan being subdivided into a sequence representing sample intervals; and
for each sampling interval:
(i) generating on a signal channel an analogue signal representing the intensity of the modulated beam of analytical radiation;
(ii) digitising a plurality of sampled signal values of said analogue signal to provide corresponding digitized values;
characterised in that;
the signal channel has a bandwidth that is wider than the range of frequencies that characterises the spectrometer output signal so that the spectrometer signal provides noise over this bandwidth; and that at least some of the digitized values are averaged.

2. A method according to claim 1 wherein all of the sampled voltages are digitized.

3. A method according to claim 1 or claim 2 wherein all the digitized values are averaged.

4. A method according to any one of claims 1 to 3 wherein said steps are performed for a plurality of scans, and further comprising the step of averaging the output values generated for corresponding sampling intervals for the plurality of scans.

5. A method according to any one of claims 1 to 4 wherein the spectrometer (7) is operated in a step scanning mode.

6. A method according to any one of claims 1 to 5 further comprising a step of digitally filtering the set of digitized values generated for at least one scan.

7. A spectrometer (7) having digitizing apparatus for providing a digitized spectrometer signal, the spectrometer (7) providing a modulated beam of analytical radiation as an optical element in the spectrometer (7) is scanned over a range of positions defining a scan, the scan being subdivided into a sequence of sampling intervals, the digitizing apparatus comprising:
means for generating on a signal channel an analogue signal (5) representing the intensity of the modulated beam of analytical radiation;
means for digitizing (82) a plurality of sampled signal values of said analogue signal to provide corresponding digitized values;
characterised in that:
(i) the signal channel has a bandwidth that is wider than the range of frequencies that characterises the spectrometer output signal so that the spectrometer signal provides noise over this bandwidth; and
(ii) averaging means (82) are provided to average at least some of the digitized values.

8. An apparatus according to claim 7 wherein the spectrometer is operable in a rapid scan mode.

## Patentansprüche

1. Verfahren zum Bereitstellen eines digitalisierten Spektrometersignals, wobei das Verfahren folgende Schritte umfaßt:
das Erzeugen eines modulierten Strahls analytischer Strahlung unter Verwendung eines Spektrometers (7), während ein optisches Element im Spektrometer (7) über einen Bereich von Positionen abgetastet wird, der eine Abtastung definiert, wobei die Abtastung in eine Sequenz unterteilt wird, die Samplingintervalle darstellt; und
für jedes Samplingintervall:
(i) ein analoges Signal auf einem Signalkanal erzeugt wird, das die Intensität des modulierten Strahls analytischer Strahlung darstellt;
(ii) eine Vielzahl aufgenommener Signalwerte des analogen Signals digitalisiert wird, um entsprechende digitalisierte Werte zu liefern;
dadurch gekennzeichnet, daß
der Signalkanal eine Bandbreite aufweist, die größer ist als der Frequenzbereich, der das Spektrometerausgangssignal charakterisiert, sodaß das Spektrometersignal über diese Bandbreite Rauschen liefert; und daß zumindest einige der digitalisierten Werte gemittelt werden.

2. Verfahren nach Anspruch 1, worin alle abgetasteten Spannungen digitalisiert werden.

3. Verfahren nach Anspruch 1 oder 2, worin alle digitalisierten Werte gemittelt werden.

4. Verfahren nach einem der Ansprüche 1 bis 3, worin die Schritte für eine Vielzahl von Abtastungen durchgeführt werden, und das weiters den Schritt der Mittelwertbildung der Ausgangswerte umfaßt, die für entsprechende Samplingintervalle für die Vielzahl von Abtastungen erzeugt werden.

5. Verfahren nach einem der Ansprüche 1 bis 4, worin das Spektrometer (7) in einem Schrittabtastmodus betrieben wird.

6. Verfahren nach einem der Ansprüche 1 bis 5, das weiters einen Schritt des digitalen Filterns des Satzes an digitalisierten Werten umfaßt, die für zumindest eine Abtastung erzeugt wurden.

7. Spektrometer (7) mit Digitalisierungsvorrichtung zum Bereitstellen eines digitalisierten Spektrometersignals, wobei das Spektrometer (7) einen modulierten Strahl analytischer Strahlung liefert, wenn ein optisches Element im Spektrometer (7) über einen Positionenbereich abgetastet wird, der eine Abtastung definiert, wobei die Abtastung in eine Sequenz von Samplingintervallen unterteilt wird, wobei die Digitalisierungsvorrichtung umfaßt:
Mittel zum Erzeugen eines analogen Signals (5) auf einem Signalkanal, das die Intensität des modulierten Strahls analytischer Strahlung darstellt;
Mittel zum Digitalisieren (82) einer Vielzahl abgetasteter Signalwerte des analogen Signals, um entsprechende digitalisierte Werte bereitzustellen;
dadurch gekennzeichnet, daß
(i) der Signalkanal eine Bandbreite aufweist, die größer ist als der Frequenzbereich, der das Spektrometerausgangssignal kennzeichnet, sodaß das Spektrometersignal über diese Bandbreite Rauschen liefert; und
(ii) Mittel zur Mittelwertbildung (82) vorgesehen sind, um aus zumindest einigen der digitalisierten Werte den Mittelwert zu bilden.

8. Vorrichtung nach Anspruch 7, worin das Spektrometer in einem raschen Abtastmodus betrieben werden kann.

## Revendications

1. Procédé pour réaliser un signal de spectromètre numérisé, ledit procédé comprenant les étapes de :
produire en utilisant un spectromètre (7) un faisceau modulé de rayonnement analytique comme un élément optique dans le spectromètre (7) est balayé sur une étendue de positions définissant un balayage, le balayage étant subdivisé en une séquence représentant des intervalles d'échantillonnage ; et
pour chaque intervalle d'échantillonnage :
(i) produire sur un canal de signaux un signal analogique représentant l'intensité du faisceau modulé de rayonnement analytique ;
(ii) numériser un certain nombre de valeurs de signaux échantillonnés dudit signal analogique pour produire des valeurs numérisées correspondantes ;
caractérisé en ce que ;
le canal de signaux a une largeur de bande qui est plus large que la gamme de fréquences qui caractèrise le signal de sortie du spectromètre de sorte que le signal du spectromètre produit du bruit sur cette largeur de bande et en ce qu'au moins certaines des valeurs numérisées sont moyennées.

2. Procédé selon la revendication 1 dans lequel toutes les tensions échantillonnées sont numérisées.

3. Procédé selon la revendication 1 ou la revendication 2 dans lequel toutes les valeurs numérisées sont moyennées.

4. Procédé selon l'une quelconque des revendications 1 à 3, dans lequel les étapes précitées sont accomplies pendant un certain nombre de balayages et comprenant de plus l'étape de moyenner la valeur de sortie produites pour des intervalles d'échantillonnage correspondant pour la pluralité de balayages.

5. Procédé selon l'une quelconque des revendications 1 à 4 dans lequel le spectromètre (7) est activé en un mode de balayage pas-à-pas.

6. Procédé selon l'une quelconque des revendications 1 à 5 comprenant de plus une étape de numériquement filtrer le jeu de valeurs numérisées produites pendant au moins un balayage.

7. Spectromètre (7) ayant un dispositif de numérisation pour produire un signal de spectromètre numérisé, le spectromètre (7) produisant un faisceau modulé de rayonnement analytique comme un élément optique dans le spectromètre (7) est balayé sur une étendue de positions définissant un balayage, le balayage étant subdivisé en une séquence d'intervalles d'échantillonnage, le dispositif de numérisation comprenant :
un moyen pour produire sur un canal de signaux un signal analogique (5) représentant l'intensité du faisceau modulé de rayonnement analytique ;
un moyen pour numériser (82) un certain nombre de signaux échantillonnés dudit signal analogique pour produire des valeurs numérisées correspondantes ;
caractérisé en ce que :
(i) le canal de signaux a une largeur de bande qui est plus large que la gamme de fréquence qui caractérise le signal de sortie du spectromètre de sorte que le signal du spectromètre produit du bruit sur cette largeur de bande ; et
(ii) des moyens moyenneurs (82) sont prévus pour moyenner au moins certaines des valeurs numérisées.

8. Dispositif selon la revendication 7 dans lequel le spectromètre est activable en un mode de balayage rapide.
